# EUROPÄISCHE PATENTSCHRIFT

(11) **EP 3 432 692 B1**
(45) Veröffentlichungstag und Bekanntmachung des Hinweises auf die Patenterteilung: **10.06.2020**
(21) Anmeldenummer: 18178017.2
(22) Anmeldetag: 15.06.2018
(51) Int. Cl.: H05K 1/02, H05K 1/11

(54) **THERMISCHE KOPPLUNG VON KUPFERSPREIZFLÄCHEN**
THERMAL COUPLING OF COPPER HEAT SPREADING SURFACES
COUPLAGE THERMIQUE DE SURFACES DE DISTRIBUTION DE CHALEUR EN CUIVRE

(30) Priorität: 18.07.2017 AT 506012017
(43) Veröffentlichungstag der Anmeldung: 23.01.2019
(73) Patentinhaber: ZKW Group GmbH, 3250 Wieselburg (AT)
(72) Erfinder: Edlinger, Erik, 1090 Wien (AT)
(74) Vertreter: Patentanwaltskanzlei Matschnig & Forsthuber OG

(56) Entgegenhaltungen:
- EP-A2- 2 397 749
- EP-A2- 2 469 593
- EP-A2- 2 685 153
- US-A1- 2004 223 327

## Beschreibung

Die Erfindung betrifft eine Leiterplatte, umfassend eine Basisschicht mit einer Ober- und einer Unterseite, wobei zumindest die Oberseite zumindest eine erste Lage von zur Stromführung vorgesehene Leiterbahnen und zumindest ein erstes und ein zweites elektrisches Bauteil aufweist, wobei ferner je einem Bauteil zumindest zwei Leiterbahnen zur Ansteuerung der Bauteile zugeordnet sind, wobei nächst benachbarte Leiterbahnen auf je einer Seite der Basisschicht zur gegenseitigen elektrischen Isolation zueinander beabstandete Grenzflächen aufweisen.

Eine Leiterplatte ist im Allgemeinen ein mit Hilfe von Kunstharz verpresstes Laminat aus kupferbeschichteten Kunststoffplatten, wobei heutzutage üblicherweise in Epoxidharz getränkte Glasfasermatten - kurz FR4 (Flame Retardant 4) genannt - für die Herstellung von Leiterplatten verwendet werden.

Das üblicherweise aus Kupfer gebildete Leiterbild auf der Ober- und Unterseite wird dabei photochemisch durch Ätzung erzeugt. Die Temperaturbeständigkeit einer solchen Leiterplatte ist allerdings beschränkt. Bei dem für Leiterplatten üblicherweise verwendeten Standardmaterial FR4 liegt die empfohlene Betriebstemperatur bei einer Dauerbelastung bei ungefähr 120 Grad Celsius, abhängig vom jeweiligen Glaspunkt des FR4. Bei höheren Temperaturen kann es zu chemischen Reaktionen, Delamination sowie Verbiegungen und dadurch zu einem Verlust der elektrischen Funktionsfähigkeit kommen. Ebenso altert das entsprechende Lot stärker und neigt zu ungewünschter Diffusion zu einer intermetallischen Zone, die anfälliger für Risse ist.

Die auf einer Leiterplatte angeordneten Bauteile, beispielsweise LEDs, besitzen eine ähnliche Temperaturgrenze und müssen entsprechend gekühlt werden bzw. muss dafür gesorgt werden, dass die von diesen Bauteilen erzeugte Wärme abgegeben wird.

Es kann sich grundsätzlich um sogenannte Leistungsbauteile handeln, deren produzierte Wärme abgeführt werden soll, beispielsweise Transistoren.

Nicht nur die Bauteile können Wärme erzeugen, die abgeführt werden sollte, sondern auch die Leiterbahnen selbst, wenn durch diese ein genügend hoher Strom fließt. Dies kann unter Umständen zu lokalen Zerstörungseffekten führen, die sich auf die gesamte Leiterplatte und deren Funktionalität auswirken können.

Die auf einer Leiterplatte angeordneten Leiterbahnen sind im Allgemeinen Leiterflächen mit unterschiedlichen Potentialen, wobei die Größe einer Leiterfläche proportional zur Wärmeabgabe an die Umgebung ist, d.h. eine größere Leiterfläche kann mehr Wärme speichern und diese auch verbessert durch deren größere Oberfläche abgeben.

Die Wärmeleitfähigkeit der beteiligten Materialien der verwendeten Bauteile ist im Gegensatz zum Kupfer der Leiterbahnen bzw. der Leiterflächen vergleichsweise schlecht. Die meisten Bauteile, beispielsweise LEDs, besitzen in der Regel nicht die für die notwendige Wärmeübertragung erforderliche Oberflächengröße und würden bei Betrieb ohne hinreichende Kühlung Schaden nehmen.

Zur gegenseitigen elektrischen Isolation sind die Grenzflächen der Leiterbahnen bzw. Leiterflächen von nächst benachbarten Leiterbahnen beabstandet zueinander angeordnet. Die Grenzflächen der Leiterbahnen einer Leiterplatte aus dem Stand der Technik verlaufen in der Regel jedoch im Wesentlichen geradlinig zueinander, sodass eine gewünschte Wärmeabfuhr von einer Leiterbahn zu einer nächst benachbarten Leiterbahn, um eine größere Oberfläche zur Wärmeabgabe eines betriebenen Bauteils an die Umgebung zu erhalten, d.h. eine sogenannte Wärmespreizung, nur unzureichend stattfinden kann.

Es sei darauf hingewiesen, dass hierfür ein Temperaturgradient bzw. Temperaturgefälle von der Wärme abgebenden Leiterbahn zu einer nächst benachbarten Leiterbahn erforderlich ist. Erst durch eine Wärmeübertragung in die bzw. durch die Leiterplatte bzw. die FR4-Basisschicht und die dortige sogenannte Wärmespreizung kann die Wärme in der Regel ausreichend an die Umgebung abgegeben werden.

Relevanter Stand der Technik wird durch EP 2 685 153 A2 und EP 2 469 593 A2 dargestellt.

Jedoch führt eine immer kleinere Bauweise solcher Leiterplatten mit einem entsprechenden Layout zu Problemen in der Wärmeabgabe der auf einer Leiterplatte angeordneten Bauteile in die bzw. durch die Leiterplatte, um die Wärme mittels Wärmespreizung abzugeben.

Es ist eine Aufgabe der Erfindung eine verbesserte Leiterplatte bereitzustellen, um oben erwähnte Nachteile und andere Einschränkungen des Standes der Technik zu vermeiden.

Diese Aufgabe wird durch eine Leiterplatte gemäß Anspruch 1 gelöst. Erfindungsgemäß weisen zumindest die Grenzfläche einer Leiterbahn des ersten Bauteils zumindest abschnittsweise einen ersten Satz Vorsprünge und die Grenzfläche einer dazu nächst benachbarten Leiterbahn des zweiten Bauteils zumindest abschnittsweise einen zweiten Satz Vorsprünge auf, wobei sich der erste Satz Vorsprünge und der zweite Satz Vorsprünge komplementär ergänzen.

Unter "komplementär ergänzen" ist in diesem Zusammenhang im Allgemeinen zu verstehen, dass die Sätze von Vorsprüngen so zueinander angeordnet sind und ineinandergreifen, dass der Abstand der jeweiligen Grenzflächen, d.h. der elektrisch isolierende Abstand der nächst benachbarten Leiterbahnen, deren Sätze von Vorsprünge ineinandergreifen, im Wesentlichen gleich bleibt.

Mit anderen Worten erzeugt jeder Satz von Vorsprüngen auf einer Grenzfläche auch "Vertiefungen", die sich zwangsläufig ergeben. Die Vorsprünge eines Satzes sind in den entstandenen "Vertiefungen" des anderen angeordnet, und zwar dermaßen, dass die Abstände aller von einer "Vertiefung" umgebenden Seiten eines Vorsprungs im Wesentlichen konstant sind.

Im Gegensatz zu den Grenzflächen einer Leiterbahn des ersten Bauteils und einer dazu nächst benachbarten Leiterbahn des zweiten Bauteils, welche Grenzflächen im Wesentlichen über weite Strecken der Leiterplatte geradlinig verlaufen, weisen die erfindungsgemäßen Sätze von Vorsprüngen eine größere Oberfläche der jeweiligen Grenzflächen auf, sodass eine gegenseitige Wärmeabgabe begünstigt wird.

Die Wärme übertragenden Grenzflächen könnten beispielsweise zusätzlich durch eine Erhöhung der Kupferstärke der jeweiligen Leiterbahn vergrößert werden.

Da im Allgemeinen versucht wird Leiterplatten immer kleiner zu gestalten, tritt das Wärmemanagement solcher Leiterplatten weiter in den Vordergrund, insbesondere bei Leiterplatten, deren Ober- als auch Unterseite mit Leiterbahnen und entsprechenden Bauteilen versehen sind und somit kein Platz für etwaige Kühlkörper zur Verfügung steht.

Daher ist durch sich komplementär ergänzende Sätze von Vorsprüngen ein verbessertes Wärmemanagement möglich; die Leiterbahn fungiert selbst als Kühlkörper, dessen Eigenschaften durch die Anordnung der Vorsprünge verbessert wird.

Es sei darauf hingewiesen, dass sich die Begriffe "Ober- und Unterseite" nicht auf eine ausgezeichnete Richtung oder Lage der Leiterplatte beziehen, sondern den für einen Fachmann bekannten Fachterminus - im Englischen auch als Top- bzw. Bottom-Layer bezeichnet- entsprechen, wobei die Ober- und Unterseite zueinander abgewandt sind.

Im Allgemeinen ist durch die Anordnung der Leiterbahnen auf der Ober- oder Unterseite der Leiterplatte zwischen nächst benachbarten Leiterflächen zweier Leiterbahnen ein solcher Abstand bzw. Zwischenraum gebildet, dass eine elektrische Isolation bei gleichzeitiger Wärmeübertragung durch Wärmeleitung bzw. Konvektion gegeben ist.

Wie bereits erwähnt, wird durch die sich komplementär ergänzenden Vorsprünge von nächst benachbarten Leiterbahnen unterschiedlicher Bauteile jeweils eine vergrößerte Oberfläche erzeugt, die eine bessere Wärmeübertragung zwischen zwei nächst benachbarten, aber elektrisch potentialgetrennten Leiterbahnen gewährleistet.

Dadurch kann nicht nur die üblicherweise verwendete Wärmeübertragung an die Umgebung über bzw. durch die Basisschicht mit anschließender Wärmespreizung, sondern auch eine Wärmespreizung "in-plane" genutzt werden.

Mit dem Begriff "in-plane" ist jeweils die Ober- bzw. die Unterseite der Basisschicht sowie die möglichen Lagen von Leiterbahnen gemeint, auf der die zumindest zwei Bauteile angeordnet sind.

Bevorzugt sind solche Vorsprünge abschnittsweise dort angeordnet, wo die Wärmeentwicklung am höchsten ist, beispielsweise im Bereich bzw. auf Höhe des ersten und/oder des zweiten Bauteils.

Grundsätzlich ist vorgesehen, dass die zumindest zwei Bauteile die Leiterbahn des jeweils anderen mit Hilfe der sich komplementär ergänzenden Vorsprünge als Wärmespreizfläche nutzen können.

Dafür muss allerdings ein Temperaturunterschied zwischen den nächst benachbarten Leiterbahnen der zumindest zwei Bauteile vorhanden sein, da sonst kein Wärmetransport bzw. Wärmeübergang im herkömmlichen Sinn stattfinden kann.

Damit ein Temperaturunterschied auftreten kann, sind mindestens zwei Szenarien möglich: 1. die zumindest zwei Bauteile haben gleiche Leistungseinträge, gleiche thermische Package-Widerstände und sind thermisch gleich gut an die Leiterplatte angebunden, 2. die zumindest zwei Bauteile haben unterschiedliche Leistungseinträge, unterschiedliche thermische Package-Widerstände oder sind thermisch unterschiedlich gut an die Leiterplatte angebunden.

Falls die zumindest zwei Bauteile Punkt 1 entsprechen, kann ein Temperaturunterschied nur auftreten, wenn diese nicht in gleicher Weise betrieben werden. Hierbei kann beispielsweise vorgesehen sein, dass jeweils immer nur eines der zumindest zwei Bauteile in Betrieb ist und das andere nicht. Dadurch kann die Leiterbahn bzw. die Leiterflächen des temporär nicht betriebenen Bauteils als Wärmespreizfläche zur Wärmeabgabe des temporär betriebenen Bauteils genutzt werden. Ebenso gibt es die Möglichkeit, dass ein Bauteil mit geringerer Leistung betrieben wird bzw. effizienter arbeitet als das andere.

Erfindungsgemäß ist auf der Ober- und Unterseite der Leiterplatte je zumindest eine erste Lage von Leiterbahnen angeordnet.

Auf der Unterseite sind zumindest ein drittes und viertes Bauteil angeordnet.

Erfindungsgemäß ist vorgesehen, dass zumindest die Grenzfläche einer Leiterbahn des dritten Bauteils zumindest abschnittsweise einen dritten Satz Vorsprünge und die Grenzfläche einer dazu nächst benachbarten Leiterbahn des vierten Bauteils zumindest abschnittsweise einen vierten Satz Vorsprünge aufweisen, wobei sich der dritte Satz Vorsprünge und der vierte Satz Vorsprünge komplementär ergänzen.

Mit Vorteil kann vorgesehen sein, wenn die Sätze von Vorsprüngen der jeweiligen Grenzbereiche der Leiterbahnen als periodisch vorragende Rechtecke ausgebildet sind.

Eine Erhöhung der Anzahl der vorragenden Rechtecke vergrößert die Oberfläche, an der Wärme abgeführt werden soll, was zu einem verbesserten Wärmeübertrag führt, wobei es abhängig von der Breite und Länge der Vorsprünge ein Maximum gibt, das im Allgemeinen bei einem Verhältnis von Breite zu Länge bei etwa 1:1 bzw. 1:2 liegt.

Jedoch ist eine Leiterfläche durch das jeweilige Leiterbahnenlayout bzw. Leiterbahn in seiner Ausdehnung begrenzt, sodass nur eine begrenzte Anzahl an vorragenden Rechtecken realisierbar ist.

Überdies kann eine zu hohe Dichte bzw. eine zu hohe Anzahl an vorragenden Rechtecken und eine zu enge Anordnung der vorragenden Rechtecke zu thermischen Einschnürungen bzw. einem sogenannten "by pass"- Effekt zwischen den Rechtecken führen.

Es kann jedoch auch günstig sein, wenn die Sätze von Vorsprüngen der jeweiligen Grenzbereiche der Leiterbahnen als periodisch vorragende Zacken ausgebildet sind.

Die oben getroffenen Definitionen und Erläuterungen betreffen ebenso die Ausführungsform mit periodisch vorragenden Zacken.

Die Maximalgröße der Vorsprünge hängt stark von der Maximalgröße der Leiterplatte bzw. der Leiterbahn, auf der die jeweiligen Vorsprünge angeordnet sind, ab. So können die Breiten und Längen der Rechtecke variieren, beispielsweise von 1 mm bis 3 cm bzw. von 1 mm bis 6 cm. Für die Zacken können die gleichen Größenordnungen gelten.

Ebenso kann es sinnvoll sein, dass der erste und der zweite Satz von Vorsprüngen, die von den jeweiligen Grenzflächen vorragen, die gleiche Fläche einnehmen, d.h. dass sich die Gesamtfläche, die von dem ersten und zweiten Satz Vorsprünge gebildet wird, im Verhältnis 50:50 auf die Sätze von Vorsprüngen aufteilt, ausgehend von jeweils einer Lage von Leiterbahnen. Andere Verhältnisse sind zwar ebenso denkbar, jedoch nicht so effizient wie das Aufteilungsverhältnis von 50:50.

Erfindungsgemäß bilden der erste und der zweite Satz von Vorsprüngen eine erste periodische Struktur.

Der dritte und der vierte Satz von Vorsprüngen bilden eine zweite periodische Struktur.

Wie bereits erwähnt müssen die Länge einer sich wiederholenden Periode der periodischen Strukturen und die Länge der vorragenden Strukturen selbst, bei den oben genannten Beispielen Rechtecke bzw. Zacken, begrenzt werden, da es sonst zu thermischen Einschnürungen kommen kann, welche die Kühlleistung verringern bzw. der "in-plane" Wärmespreizung entgegenstehen.

Erfindungsgemäß ist die erste periodische Struktur auf der Oberseite der Leiterplatte derart über der zweiten periodischen Struktur auf der Unterseite der Leiterplatte angeordnet, dass die periodischen Strukturen um eine halbe Periode versetzt zueinander und überlappend angeordnet sind.

Mit dem Begriff "überlappend" ist gemeint, dass die von einer Grenzfläche vorragenden Rechtecke, Zacken oder auch andere Strukturen der ersten periodischen Struktur und die von einer Grenzfläche vorragenden Rechtecke, Zacken oder andere Strukturen der zweiten periodischen Struktur, die jedoch um eine halbe Periode versetzt sind, in einer Sicht von oben auf die Oberseite der Leiterplatte bzw. einer Sicht von unten auf die Unterseite der Leiterplatte übereinander angeordnet sind.

Es kann vorgesehen sein, dass die Basisschicht im Bereich der übereinanderliegenden ersten und zweiten periodischen Struktur ein Keramik-Inlay aufweist.

Eine solche Keramik begünstigt vorzugsweise in diesem Bereich die Wärmeübertragung durch die Basisschicht.

Weiters kann es vorteilhaft sein, wenn auf der Oberseite der Leiterplatte ferner zumindest eine zweite Lage von Leiterbahnen angeordnet ist, wobei zumindest die Grenzfläche einer Leiterbahn zumindest abschnittsweise einen ersten Satz Vorsprünge und die Grenzfläche einer dazu nächst benachbarten Leiterbahn zumindest abschnittsweise einen zweiten Satz Vorsprünge aufweisen, wobei sich der erste Satz Vorsprünge und der zweite Satz Vorsprünge komplementär ergänzen.

Ebenso kann es vorteilhaft sein, wenn auf der Unterseite der Leiterplatte ferner zumindest eine zweite Lage von Leiterbahnen angeordnet ist, wobei zumindest die Grenzfläche einer Leiterbahn zumindest abschnittsweise einen ersten Satz Vorsprünge und die Grenzfläche einer dazu nächst benachbarten Leiterbahn zumindest abschnittsweise einen zweiten Satz Vorsprünge aufweisen, wobei sich der erste Satz Vorsprünge und der zweite Satz Vorsprünge komplementär ergänzen.

Dabei kann es günstig sein, wenn der erste und der zweite Satz von Vorsprüngen der zweiten Lage auf der Oberseite der Leiterplatte eine zweite periodische Struktur bilden.

Ebenso kann es günstig sein, wenn der erste und der zweite Satz von Vorsprüngen der zweiten Lage auf der Unterseite der Leiterplatte eine zweite periodische Struktur bilden.

Mit Vorteil ist vorgesehen, wenn die erste periodische Struktur der ersten Lage auf der Oberseite der Leiterplatte derart über der zweiten periodischen Struktur der zweiten Lage auf der Oberseite der Leiterplatte angeordnet ist, dass die periodischen Strukturen um eine halbe Periode versetzt zueinander und überlappend angeordnet sind.

Es kann weiterhin vorteilhaft sein, wenn die erste periodische Struktur der ersten Lage auf der Unterseite der Leiterplatte derart über der zweiten periodischen Struktur der zweiten Lage auf der Unterseite der Leiterplatte angeordnet ist, dass die periodischen Strukturen um eine halbe Periode versetzt zueinander und überlappend angeordnet sind.

Vorteilhafterweise kann zumindest das erste und das zweite Bauteil als optoelektronisches Bauteil ausgebildet sein.

Es kann vorgesehen sein, dass zumindest das erste und das zweite Bauteile als LED ausgebildet ist.

In einer weiteren Ausführungsform kann vorgesehen sein, dass zumindest das erste und das zweite Bauteil als Laserdiode ausgebildet sind.

Mit Vorteil kann vorgesehen sein, dass zumindest ein Betriebsmodus vorgesehen ist, bei welchem die Bauteile abwechselnd betreibbar sind.

Weiters kann es vorteilhaft sein, wenn die Basisschicht aus einem elektrisch isolierenden Verbundwerkstoff gebildet ist.

Hierbei kann es günstig sein, wenn die Basisschicht aus FR4 gebildet ist.

Für die Erfindung können vor allem auch Leiterplatten vorgesehen sein, die keinen zusätzlichen Kühlkörper verwenden.

Ebenso sind aber auch Leiterplatten mit einem zusätzlichen Kühlkörper denkbar, um beispielsweise den Kühlkörper zu entlasten. Hierbei kann es sich beispielsweise um eine IMS (Insulated Metal Substrate) Leiterplatte handeln, die üblicherweise aus Aluminium gefertigt ist und nur auf einer Seite mit einem Leiterbahnenlayout mit Bauteilen versehen ist und üblicherweise mit einem separaten Kühlkörper betrieben wird.

Nachfolgend wird die Erfindung beispielhaft anhand von Zeichnungen näher erläutert.

### Hierbei zeigt

Fig. 1 einen Ausschnitt einer Leiterplatte mit elektrischen Bauteilen aus dem Stand der Technik,
Fig. 2 einen Ausschnitt einer beispielhaften Leiterplatte mit elektrischen Bauteilen, wobei nächst benachbarte Leiterbahnen der verschiedenen Bauteile eine sich komplementär ergänzende, periodische Struktur aufweisen,
Fig. 3 eine Ansicht von oben des Ausschnitts der Leiterplatte aus Fig. 2,
Fig. 4 eine Ansicht von oben durch den Ausschnitt der Leiterplatte aus Fig. 2 auf die Unterseite der Leiterplatte,
Fig. 5 einen Ausschnitt der nächst benachbarten Leiterbahnen auf der Ober- und Unterseite der beispielhaften Leiterplatte, wobei sich die periodischen Strukturen der Ober- bzw. Unterseite, welche als vorragende Rechtecke ausgebildet sind, um eine halbe Periode verschoben überlappen,
Fig. 6 eine Ansicht von oben einer weiteren beispielhaften Leiterplatte,
Fig. 7 eine Ansicht von oben durch die Leiterplatte aus Fig. 6 auf die Unterseite der Leiterplatte,
Fig. 8 eine schematische Darstellung der Wärmeentwicklung einer Leiterplatte aus dem Stand der Technik,
Fig. 9 eine schematische Darstellung der Wärmeentwicklung bzw. Wärmespreizung der beispielhaften Leiterplatte aus Fig. 2, 3 und 4.
Fig. 10 einen Ausschnitt der nächst benachbarten Leiterbahnen auf der Ober- und Unterseite der beispielhaften Leiterplatte, wobei sich die periodischen Strukturen der Ober- bzw. Unterseite, welche als vorragende Zacken ausgebildet sind, um eine halbe Periode verschoben überlappen,
Fig. 11 eine Ansicht von oben bzw. eine Draufsicht des Ausschnitts aus Fig. 10, wobei die Unterseite strichliert dargestellt ist,
Fig. 12 eine weitere Leiterplatte aus dem Stand der Technik mit zwei Lagen von Leiterbahnen auf der Oberseite,
Fig. 13 eine Leiterplatte mit zwei Lagen von Leiterbahnen auf der Oberseite, welche Lagen jeweils eine periodische Struktur auf den Grenzflächen aufweisen, und
Fig. 14 eine Leiterplatte mit jeweils zwei Lagen von Leiterbahnen auf der Ober- und Unterseite, wobei die Basisschicht im Bereich der übereinanderliegenden periodischen Strukturen ein Keramik-Inlay aufweist.

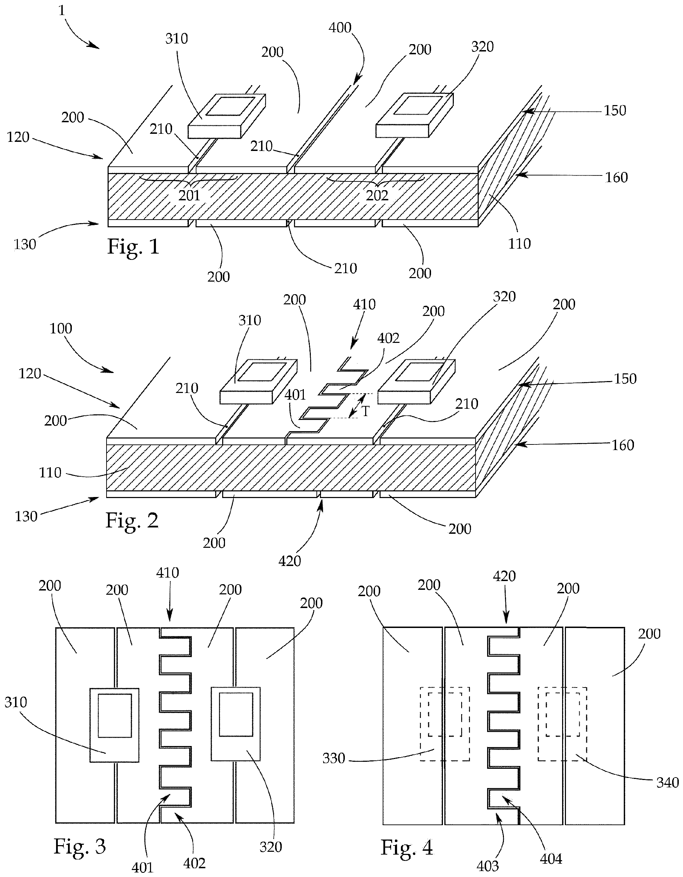

In **Fig. 1** ist eine perspektivische Ansicht eines Ausschnitts einer Leiterplatte **1** aus dem Stand der Technik gezeigt, wobei die Leiterplatte **1** in dieser Figur eine aus FR4 gebildete Basisschicht **110** mit einer Ober- und einer Unterseite **120, 130** umfasst, welche jeweils eine erste Lage **150, 160** von zur Stromführung vorgesehene Leiterbahnen **200** aufweisen, wobei die Oberseite **120** ein erstes **310** und ein zweites Bauteil **320** umfasst, die hier als LED ausgeführt sind. Auf der Unterseite **130** der Basisschicht **110** ist ein drittes **330** und ein viertes Bauteil **340** angeordnet, welche jedoch in der Figur nicht sichtbar sind.

Hierbei sind jedem Bauteil **310, 320, 330, 340** jeweils zwei Leiterbahnen **200** mit unterschiedlichen Potentialen zur Ansteuerung zugeordnet, wie unter anderem in **Fig. 1** dargestellt. Zur gegenseitigen elektrischen Isolation weisen die Leiterbahnen **200** eine zueinander beabstandete Grenzfläche **210** auf, wobei deren Abstand in der Regel einen gegenseitigen Wärmeübertrag bzw. Wärmeaustausch ermöglicht.

Bei einer übermäßigen Wärmeentwicklung eines Bauteils, d.h. wenn Temperaturen erreicht werden, die der optimalen Funktionsweise entgegenstehen, kann und wird die Wärme hauptsächlich durch die Basisschicht **110** und über weitere Wärmespreizung an die Umgebung abgeführt.

**Fig. 2** zeigt eine beispielhafte Ausführungsform der Erfindung, wobei im Gegensatz zu einer Leiterplatte **1** aus dem Stand der Technik die beabstandete Grenzfläche **210** einer Leiterbahn **200** des ersten Bauteils **310** und die Grenzfläche **210** einer dazu nächst benachbarten Leiterbahn **200** des zweiten Bauteils **320** nicht geradlinig verlaufen, sondern eine erste zueinander komplementäre periodische Struktur **410** aufweisen, die von einem ersten und einem zweiten Satz von Vorsprüngen **401, 402** der jeweiligen Grenzflächen **210** der Leiterbahnen **200** auf der Oberseite **120** gebildet wird, wobei die Sätze von Vorsprünge als periodisch vorragende Rechtecke ausgebildet sind, wie in **Fig. 2** zu sehen ist.

Es sei darauf hingewiesen, dass aufgrund der Übersichtlichkeit und der weiteren Erklärungen die Figuren lediglich Ausschnitte einer Leiterplatte darstellen und es vorgesehen sein kann, dass weitere Bauteile und Leiterbahnen auf der Basisschicht angeordnet sind.

Weiters beziehen sich die Begriffe "Ober- und Unterseite" nicht auf eine ausgezeichnete Richtung oder Lage der Leiterplatte, sondern entspricht den für einen Fachmann bekannten Fachterminus - im Englischen auch als Top- bzw. Bottom-Layer bezeichnet.

Ebenso sind räumliche Angaben wie "oben", "unten", "über", "unter" hinsichtlich der Ausrichtungen in den Figuren zu verstehen, falls keine ergänzenden Richtungsangaben bzw. Ausrichtungen zu einer Figur beschrieben sind.

Hierzu zeigt **Fig. 3** eine Sicht von oben bzw. eine Draufsicht der Oberseite **120** der Leiterplatte **100** aus **Fig. 2** mit dem ersten und dem zweiten Bauteil **310, 320** sowie der ersten periodischen Struktur **410.**

Auf der Unterseite **130** der Basisschicht **110**, welche in **Fig. 2** jedoch nicht eindeutig zu sehen ist, weisen die Grenzfläche **210** einer Leiterbahn **200** des dritten Bauteils **330** und die Grenzfläche **210** einer dazu nächst benachbarten Leiterbahn **200** des vierten Bauteils **340** auf der Unterseite eine erste zueinander komplementäre Struktur **420** auf, die ebenfalls von den jeweiligen Grenzflächen **210** der Leiterbahnen **200** als periodisch vorragende Rechtecke ausgebildet ist.

Hierzu zeigt **Fig. 4** eine Sicht von oben bzw. eine Durchsicht auf die Unterseite **130** der Leiterplatte **100** aus **Fig. 2** mit dem dritten und dem vierten Bauteil **330, 340** sowie der ersten periodischen Struktur **420** auf der Unterseite.

Die ersten periodischen Strukturen **410, 420** weisen beide eine definierte Periode T auf, wobei die ersten periodischen Strukturen **410, 420** in **Fig. 2** derart übereinander angeordnet sind, dass die periodischen Strukturen um eine halbe Periode **T** versetzt zueinander und überlappend angeordnet sind.

Mit dem Begriff "überlappend" ist gemeint, dass die von einer Grenzfläche **210** vorragenden Rechtecke der ersten periodischen Struktur **410** auf der Oberseite **120** der Leiterplatte und die von einer Grenzfläche **210** vorragenden Rechtecke der ersten periodischen Struktur **420** der Unterseite **130** der Leiterplatte, welche Strukturen jedoch um eine halbe Periode T versetzt sind, in einer Sicht von oben auf die Oberseite **120** der Leiterplatte **100** bzw. einer Sicht von oben durch die Leiterplatte auf die Unterseite **130** der Leiterplatte **100** übereinander angeordnet sind.

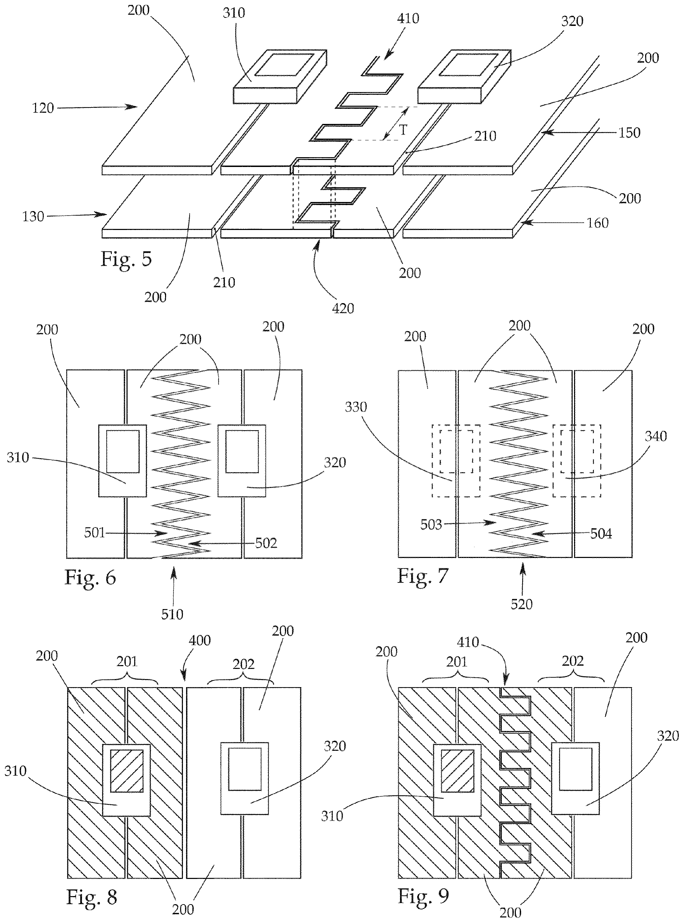

Hierzu zeigt **Fig. 5** die Leiterbahnen **200** und die Bauteile **310, 320** der Oberseite **120** der Leiterplatte **100** sowie die Leiterbahnen **200** der Unterseite **130** der Leiterplatte **100**, wobei die Basisschicht **110** nicht dargestellt ist, um die zueinander um eine halbe Periode T versetzt und überlappend angeordneten periodischen Strukturen **410, 420** besser zu veranschaulichen.

Die periodischen Strukturen **410, 420**, die jeweils als zueinander komplementär ergänzende, vorragende Rechtecke ausgebildet sind, können auch als von den jeweiligen Grenzflächen **210** vorragende Zacken ausgebildet sein, die sich zueinander komplementär ergänzen, wie in **Fig. 6**, **7**, **10** und **11** gezeigt ist.

**Fig. 6** zeigt eine Sicht von oben bzw. eine Draufsicht der Oberseite **120** der Leiterplatte **100** mit dem ersten und dem zweiten Bauteil **310, 320** sowie der ersten periodischen Struktur **510,** welche in diesem Beispiel von einem ersten und zweiten Satz von Vorsprüngen **501, 502** der jeweiligen Grenzflächen **210** gebildet ist, wobei die Sätze von Vorsprüngen **501, 502** als periodisch vorragende Zacken ausgebildet sind.

**Fig. 7** zeigt eine Sicht von oben bzw. eine Durchsicht auf die Unterseite **130** der Leiterplatte **100** mit dem dritten und dem vierten Bauteil **330, 340** sowie der ersten periodischen Struktur **520** auf der Unterseite der Leiterplatte, welche in diesem Beispiel als von den jeweiligen Grenzflächen **210** periodisch vorragende Zacken ausgebildet ist.

In der bevorzugten Ausführungsform, die in den Figuren gezeigt, aber nicht als einschränkendes Beispiel zu verstehen ist, ist das erste und das zweite Bauteil **310, 320** als LED ausgebildet, wobei diese in einem Betriebsmodus betrieben werden, bei welchem jeweils nur eine der LEDs aktiv bzw. eingeschalten und die andere inaktiv bzw. ausgeschalten ist.

Bei diesem Betriebsmodus, der jeweils in **Fig. 8** und **9** illustriert ist, wird sichergestellt, dass die der jeweils inaktiven bzw. ausgeschalteten LED zugeordneten Leiterbahnen **200** eine niedrigere Temperatur aufweisen als die Leiterbahnen **200**, die der jeweils aktiven bzw. eingeschalteten LED zugeordnet sind.

Hierzu zeigt **Fig. 8** eine Sicht von oben bzw. eine Draufsicht der Oberseite **120** der Leiterplatte **1** aus dem Stand der Technik mit einer aktiven bzw. eingeschalteten ersten LED **310**, deren Aktivität durch eine von links unten, nach rechts oben gerichtete Schraffur dargestellt ist, und einer inaktiven bzw. ausgeschalteten zweiten LED **320.**

Für weitere Erläuterungen werden Leiterbahnen **200**, die dem ersten Bauteil bzw. der ersten LED **310** zugeordnet sind, auch als erstes Leiterbahnenpaar **201** und Leiterbahnen **200**, die dem zweiten Bauteil bzw. der zweiten LED **320** zugeordnet sind, auch als zweites Leiterbahnenpaar **202** bezeichnet.

Das durch den Betrieb der ersten LED **310** erwärmte Leiterbahnenpaar **201** ist durch eine von links oben, nach rechts unten gerichtete Schraffur gekennzeichnet.

Es hat sich gezeigt, dass die Grenzflächen der im Stand der Technik zueinander beabstandeten Leiterbahnenpaare **201**, **202**, welche Grenzflächen im Wesentlichen geradlinig zueinander verlaufen, keinen ausreichenden, gegenseitigen Wärmeübertrag gewährleisten, sodass, wie im Beispiel aus **Fig. 8**, das erste Leiterbahnenpaar **201** die Wärme nicht über die zueinander beabstandeten Grenzflächen der Leiterbahnenpaare **201, 202** übertragen kann, selbst wenn, wie im Beispiel aus **Fig. 8**, das zweite Leiterbahnenpaar **202** aufgrund der inaktiven bzw. ausgeschalteten LED **320** eine niedrigere Temperatur aufweist als das erste Leiterbahnenpaar **201.**

Im Gegensatz dazu zeigt **Fig. 9** eine Sicht von oben bzw. eine Draufsicht auf die Oberseite **120** der Leiterplatte **100** mit einer aktiven bzw. eingeschalteten ersten LED **310**, deren Aktivität durch eine von links unten, nach rechts oben gerichtete Schraffur dargestellt ist, und einer inaktiven bzw. ausgeschalteten zweiten LED **320**, wobei die erfindungsgemäße erste periodische Struktur **410** auf der Oberseite **120** der Leiterplatte - hier als von den Grenzflächen **210** vorragende, sich zueinander komplementär ergänzende Rechtecke ausgebildet - einen Wärmeübertrag des ersten Leiterbahnenpaares **201**, das durch den Betrieb der ersten LED **310** eine höhere Temperatur als das zweite Leiterbahnenpaar **202** aufweist und wie in **Fig. 8** durch eine von links oben, nach rechts unten gerichtete Schraffur gekennzeichnet ist, auf die zum ersten Leiterbahnenpaar **201** nächst benachbarte Leiterbahn **200** des zweiten Leiterbahnenpaares **202** ermöglicht, was ebenfalls durch eine von links oben, nach rechts unten gerichtete Schraffur gekennzeichnet ist.

Der Wärmeübertrag wird durch die vergrößerte Oberfläche der jeweiligen Grenzflächen **201** der nächst benachbarten Leiterbahnenpaare **201, 202** ermöglicht.

Es sei darauf hingewiesen, dass neben dem oben beschriebenen Betriebsmodus auch andere Betriebsmodi möglich sind, solange die Leiterbahnenpaare **201, 202** eine unterschiedlich hohe Temperatur aufweisen, also ein Temperaturgradient zwischen den Leiterbahnenpaaren **201, 202** vorhanden ist.

So kann beispielsweise vorgesehen sein, dass eine LED gedimmt betrieben wird, wohingegen die andere LED mit maximaler Leuchtkraft betrieben wird. Ferner kann vorgesehen sein, dass das erste Bauteil verschieden von dem zweiten Bauteil ist, wobei die beiden Bauteile eine unterschiedlich hohe maximale Betriebstemperatur besitzen.

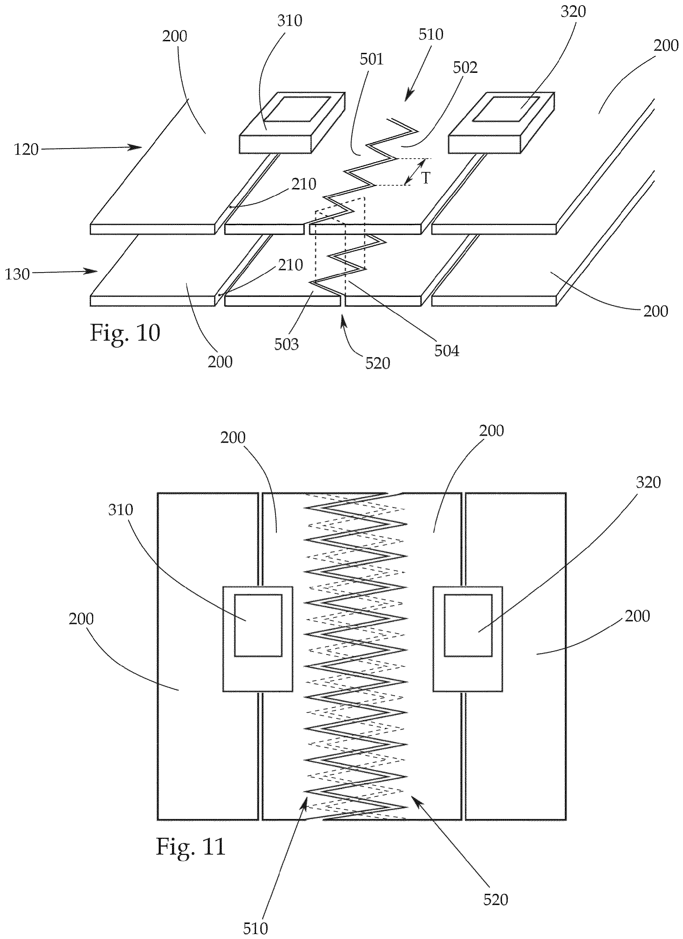

**Fig. 10** zeigt wie **Fig. 5** die Leiterbahnen **200** und die Bauteile **310**, **320** der Oberseite **120** der Leiterplatte **100** sowie die Leiterbahnen **200** der Unterseite **130** der Leiterplatte, wobei die Basisschicht **110** und die Bauteile **330**, **340** der Unterseite **130** nicht dargestellt sind. Die periodischen Strukturen **510**, **520** sind hierbei als vorragende Zacken der jeweiligen Grenzflächen **210** ausgebildet, wobei sich die periodischen Strukturen um eine halbe Periode T versetzt überlappen.

Zur besseren Veranschaulichung zeigt **Fig. 11** die Leiterplattenanordnung aus **Fig. 10** in einer Sicht von oben, wobei die erste periodische Struktur **520** der Unterseite **130** strichliert dargestellt ist.

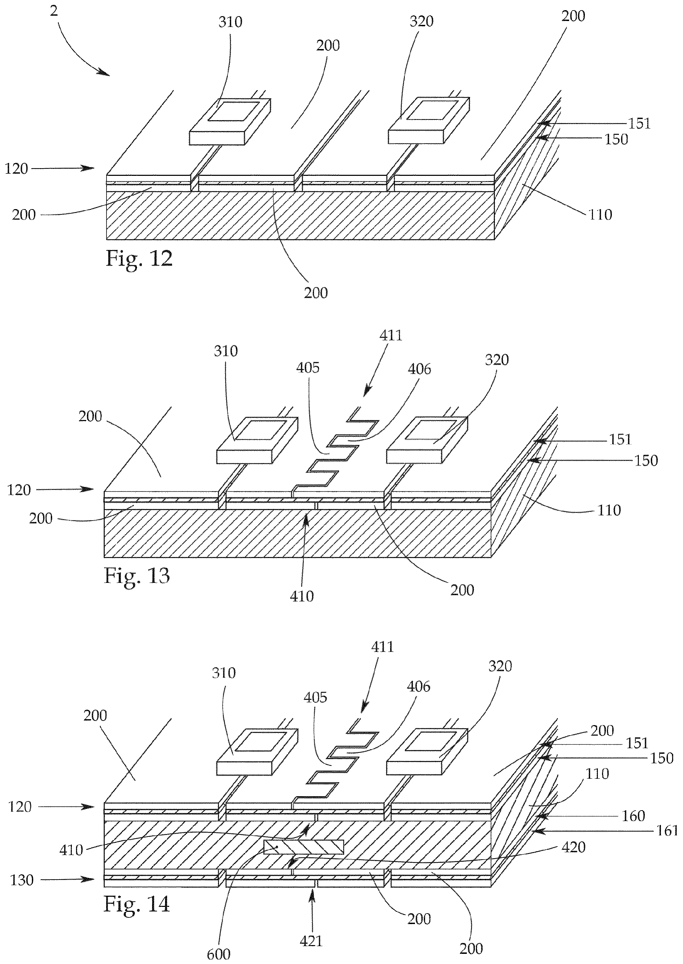

**Fig. 12** zeigt eine weitere Leiterplatte **2** aus dem Stand der Technik mit einem ersten und einem zweiten Bauteil **310, 320**, wobei auf der Oberseite dieser Leiterplatte eine zweite Lage **151** von Leiterbahnen **200** angeordnet ist.

**Fig. 13** zeigt einen Ausschnitt einer Leiterplatte mit einer zusätzlichen zweiten Lage **151** auf der Oberseite der Leiterplatte **100** sowie einem ersten und zweiten Bauteil **310, 320**, wobei die Grenzflächen **210** der ersten und der zweiten Lage **150, 151** von Leiterbahnen **200** auf der Oberseite **120** jeweils einen ersten und einen zweiten Satz von Vorsprüngen **401, 402, 405, 406** aufweisen, die jeweils eine periodische Struktur **410, 411** mit einer Periode **T** bilden, wobei die Sätze von Vorsprüngen **401, 402** von der ersten Lage **150** in dieser Figur nicht zu sehen sind, und wobei die erste periodische Struktur **410** der ersten Lage **150** auf der Oberseite **120** der Leiterplatte **100** derart zu der zweiten periodischen Struktur **411** der zweiten Lage **151** auf der Oberseite **120** der Leiterplatte **100** angeordnet ist, dass die periodischen Strukturen **410, 411** um eine halbe Periode **T** versetzt zueinander und überlappend angeordnet sind.

Der gleiche Sachverhalt trifft in **Fig. 14** ebenfalls auf die erste und zweite Lage **160, 161** auf der Unterseite **130** der Leiterplatte zu, wobei die periodischen Strukturen **411, 421** der jeweils zweiten Lagen **160** der Ober- und Unterseite **120, 130** derart übereinander angeordnet sind, dass die periodischen Strukturen **411, 421** um eine halbe Periode **T** versetzt zueinander und überlappend angeordnet sind.

Zusätzlich kann vorgesehen sein, dass in der Basisschicht **110** im Bereich der übereinanderliegenden periodischen Strukturen **410, 411, 420, 421** ein Keramik-Inlay **600** angeordnet ist, wie in **Fig. 14** dargestellt ist.

**BEZUGSZEICHENLISTE**

| | |
|---|---|
| Leiterplatte aus dem Stand der Technik... | 1, 2 |
| Leiterplatte... | 100 |
| Basisschicht... | 110 |
| Oberseite... | 120 |
| Unterseite... | 130 |
| Erste Lage Leiterbahnen... | 150, 160 |
| Zweite Lage Leiterbahnen... | 151, 161 |
| Leiterbahn... | 200 |
| erstes Leiterbahnenpaar... | 201 |
| zweites Leiterbahnenpaar... | 202 |
| Grenzfläche... | 210 |
| Bauteile... | 310, 320, 330, 340 |
| geradlinige Struktur... | 400 |
| erste Sätze Vorsprünge auf der Oberseite... | 401, 405, 501 |
| zweite Sätze Vorsprünge auf der Oberseite... | 402, 406, 502 |
| erste Sätze Vorsprünge auf der Unterseite... | 403, 503 |
| zweite Sätze Vorsprünge auf der Unterseite... | 404, 504 |
| erste periodische Struktur... | 410, 420, 510, 520 |
| zweite periodische Struktur... | 411, 421 |
| Keramik-Inlay... | 600 |

## Patentansprüche

1. Leiterplatte (100), umfassend eine Basisschicht (110) mit einer Ober- und einer Unterseite (120,130), wobei die Ober- und Unterseite (120, 130) der Leiterplatte je zumindest eine erste Lage (150, 160) von zur Stromführung vorgesehene Leiterbahnen (200) und zumindest ein erstes und ein zweites elektrisches Bauteil (310, 320) aufweist, wobei ferner je einem Bauteil (310, 320, 330, 340) zumindest zwei Leiterbahnen (200) zur Ansteuerung der Bauteile zugeordnet sind, wobei nächst benachbarte Leiterbahnen (200) auf je einer Seite (120, 130) der Basisschicht (110) zur gegenseitigen elektrischen Isolation zueinander beabstandete Grenzflächen (210) aufweisen,
wobei zumindest die Grenzfläche (210) einer Leiterbahn (200) des ersten Bauteils (310) zumindest abschnittsweise einen ersten Satz Vorsprünge (401, 405, 501) und die Grenzfläche (210) einer dazu nächst benachbarten Leiterbahn (200) des zweiten Bauteils (320) zumindest abschnittsweise einen zweiten Satz Vorsprünge (402, 406, 502) aufweisen, wobei sich der erste Satz Vorsprünge (401, 405, 501) und der zweite Satz Vorsprünge (402, 406, 502) komplementär ergänzen, wobei der erste und der zweite Satz von Vorsprüngen (401, 402, 501, 502) der zumindest einen ersten Lage (150) auf der Oberseite (120) der Leiterplatte eine erste periodische Struktur (410, 510) mit einer Periode (T) bilden,
**dadurch gekennzeichnet, dass**
auf der Unterseite (130) zumindest ein drittes und viertes Bauteil (330, 340) angeordnet sind, wobei zumindest die Grenzfläche (210) einer Leiterbahn (200) des dritten Bauteils (330) zumindest abschnittsweise einen ersten Satz Vorsprünge (403, 503) und die Grenzfläche (210) einer dazu nächst benachbarten Leiterbahn (200) des vierten Bauteils (340) zumindest abschnittsweise einen zweiten Satz Vorsprünge (404, 504) aufweisen, wobei sich der erste Satz Vorsprünge (403, 503) und der zweite Satz Vorsprünge (404, 504) komplementär ergänzen, wobei der erste und der zweite Satz von Vorsprüngen (403, 404, 503, 504) der zumindest einen ersten Lage (160) auf der Unterseite (130) der Leiterplatte eine erste periodische Struktur (420, 520) mit einer Periode (T) bilden, und wobei die erste periodische Struktur (410, 510) der zumindest einen ersten Lage (150) auf der Oberseite (120) der Leiterplatte (100) derart über der ersten periodischen Struktur (420, 520) der zumindest einen ersten Lage (160) auf der Unterseite (130) der Leiterplatte (100) angeordnet ist, dass die periodischen Strukturen (410, 420, 510, 520) um eine halbe Periode (T) versetzt zueinander und überlappend angeordnet sind, wobei vorzugsweise die Basisschicht (110) im Bereich der übereinanderliegenden ersten periodischen Struktur (410, 420, 510, 520) ein Keramik-Inlay aufweist.

2. Leiterplatte nach Anspruch 1, **dadurch gekennzeichnet, dass** die Sätze von Vorsprüngen (401, 402, 403, 404) der jeweiligen Grenzflächen (210) der Leiterbahnen (200) als vorragende Rechtecke ausgebildet sind.

3. Leiterplatte nach Anspruch 1, **dadurch gekennzeichnet, dass** die Sätze von Vorsprüngen (501, 502, 503, 504) der jeweiligen Grenzflächen (210) der Leiterbahnen (200) als vorragende Zacken ausgebildet sind.

4. Leiterplatte nach einem der Ansprüche 1 bis 3, **dadurch gekennzeichnet, dass** auf der Oberseite (120) der Leiterplatte ferner zumindest eine zweite Lage (151) von Leiterbahnen (200) angeordnet ist, wobei zumindest die Grenzfläche (210) einer Leiterbahn (200) zumindest abschnittsweise einen ersten Satz Vorsprünge (405) und die Grenzfläche (210) einer dazu nächst benachbarten Leiterbahn (200) zumindest abschnittsweise einen zweiten Satz Vorsprünge (406) aufweisen, wobei sich der erste Satz Vorsprünge (405) und der zweite Satz Vorsprünge (406) komplementär ergänzen.

5. Leiterplatte nach einem der Ansprüche 1 bis 4, **dadurch gekennzeichnet, dass** auf der Unterseite (130) der Leiterplatte ferner zumindest eine zweite Lage (161) von Leiterbahnen (200) angeordnet ist, wobei zumindest die Grenzfläche (210) einer Leiterbahn (200) zumindest abschnittsweise einen ersten Satz Vorsprünge und die Grenzfläche (210) einer dazu nächst benachbarten Leiterbahn (200) zumindest abschnittsweise einen zweiten Satz Vorsprünge aufweisen, wobei sich der erste Satz Vorsprünge und der zweite Satz Vorsprünge komplementär ergänzen.

6. Leiterplatte nach Anspruch 4 oder 5, **dadurch gekennzeichnet, dass** der erste und der zweite Satz von Vorsprüngen (405, 406) der zweiten Lage (151) auf der Oberseite (120) der Leiterplatte eine zweite periodische Struktur (411) mit einer Periode (T) bilden.

7. Leiterplatte nach einem der Ansprüche 4 bis 6, **dadurch gekennzeichnet, dass** der erste und der zweite Satz von Vorsprüngen der zweiten Lage (160) auf der Unterseite (130) der Leiterplatte eine zweite periodische Struktur (421) mit einer Periode (T) bilden, wobei vorzugsweise die erste periodische Struktur (410) der ersten Lage (150) auf der Oberseite (120) der Leiterplatte (100) derart zu der zweiten periodischen Struktur (411) der zweiten Lage (151) auf der Oberseite (120) der Leiterplatte (100) angeordnet ist, dass die periodischen Strukturen (410, 411) um eine halbe Periode (T) versetzt zueinander und überlappend angeordnet sind.

8. Leiterplatte nach Anspruch 7, **dadurch gekennzeichnet, dass** die erste periodische Struktur (420) der ersten Lage (160) auf der Unterseite (130) der Leiterplatte (100) derart zu der zweiten periodischen Struktur (421) der zweiten Lage (161) auf der Unterseite (130) der Leiterplatte (100) angeordnet ist, dass die periodischen Strukturen (420, 421) um eine halbe Periode (T) versetzt zueinander und überlappend angeordnet sind.

9. Leiterplatte nach einem der Ansprüche 1 bis 8, **dadurch gekennzeichnet, dass** zumindest das erste und/oder das zweite Bauteil (310, 320) als optoelektronisches Bauteil ausgebildet ist, wobei vorzugsweise zumindest das erste und/oder das zweite Bauteil (310, 320) als LED ausgebildet ist, wobei insbesonders zumindest das erste und/oder das zweite Bauteil (310, 320) als Laserdiode ausgebildet ist.

10. Leiterplatte nach einem der Ansprüche 7 bis 9, **dadurch gekennzeichnet, dass** zumindest ein Betriebsmodus vorgesehen ist, bei welchem die Bauteile (310, 320) abwechselnd betreibbar sind.

11. Kraftfahrzeugscheinwerfer, umfassend eine oder mehrere Leiterplatten (100) gemäß einem der Ansprüche 1 bis 10.

## Claims

1. A printed circuit board (100) comprising a base layer (110) with a top and a bottom side (120, 130), wherein the top and bottom sides (120, 130) of the printed circuit board each comprise at least one first layer (150, 160) of conductor tracks (200) provided for conducting current and at least one first and one second electrical component (310, 320), wherein further at least two conductor tracks (200) are associated with each component (310, 320, 330, 340) for driving the components, wherein next adjacent conductor tracks (200) on each side (120, 130) of the base layer (110) have mutually spaced boundary surfaces (210) for mutual electrical insulation, wherein at least the boundary surface (210) of a conductor track (200) of the first component (310) has at least in sections a first set of projections (401, 405, 501) and the boundary surface (210) of a conductor track (200) of the second component (320) next thereto has at least in sections a second set of projections (402, 406, 502), wherein the first set of projections (401, 405, 501) and the second set of projections (402, 406, 502) complement each other, wherein the first and the second set of projections (401, 402, 501, 502) of the at least one first layer (150) on the top side (120) of the printed circuit board form a first periodic structure (410, 510) with a period (T),
**characterised in that**
at least one third and one fourth component (330, 340) are arranged on the underside (130), wherein at least the boundary surface (210) of a conductor track (200) of the third component (330) has at least in sections a first set of projections (403, 503) and the boundary surface (210) of a conductor track (200) of the fourth component (340) next thereto has at least in sections a second set of projections (404), 504), wherein the first set of projections (403, 503) and the second set of projections (404, 504) complement each other, wherein the first and the second set of projections (403, 404, 503, 504) of the at least one first layer (160) on the underside (130) of the printed circuit board form a first periodic structure (420, 520) with a period (T), and wherein
the first periodic structure (410, 510) of the at least one first layer (150) on the upper side (120) of the printed circuit board (100) is arranged in such a way above the first periodic structure (420, 520) of the at least one first layer (160) on the lower side (130) of the printed circuit board (100), **in that** the periodic structures (410, 420, 510, 520) are arranged offset from one another by half a period (T) and overlapping, preferably the base layer (110) having a ceramic inlay in the region of the first periodic structure (410, 420, 510, 520) lying one above the other.

2. A printed circuit board according to claim 1, **characterised in that** the sets of projections (401, 402,403,404) of the respective boundary surfaces (210) of the conductor tracks (200) are formed as projecting rectangles.

3. A printed circuit board according to claim 1, **characterized in that** the sets of projections (501, 502, 503, 504) of the respective boundary surfaces (210) of the conductor tracks (200) are formed as projecting prongs.

4. A printed circuit board according to any one of claims 1 to 3, **characterized in that** at least one second layer (151) of conductor tracks (200) is further arranged on the upper side (120) of the printed circuit board, wherein at least the boundary surface (210) of a conductor track (200) has at least in sections a first set of projections (405) and the boundary surface (210) of a conductor track (200) next thereto has at least in sections a second set of projections (406), wherein the first set of projections (405) and the second set of projections (406) complement each other in a complementary manner.

5. A printed circuit board according to one of claims 1 to 4, **characterized in that** at least one second layer (161) of conductor tracks (200) is also arranged on the underside (130) of the printed circuit board, at least the boundary surface (210) of a conductor track (200) having at least in sections a first set of projections and the boundary surface (210) of a conductor track (200) next thereto having at least in sections a second set of projections, the first set of projections and the second set of projections complementing one another in a complementary manner.

6. A printed circuit board according to claim 4 or 5, **characterized in that** the first and the second set of projections (405, 406) of the second layer (151) on the upper side (120) of the printed circuit board form a second periodic structure (411) with a period (T).

7. A printed circuit board according to any one of claims 4 to 6, **characterized in that** the first and the second set of projections of the second layer (160) on the underside (130) of the printed circuit board form a second periodic structure (421) with a period (T), preferably the first periodic structure (410) of the first layer (150) on the upper side (120) of the printed circuit board (100) being aligned with the second periodic structure (411) of the second layer (151) on the underside (130) of the printed circuit board (100) in such a way that the first periodic structure (410) of the first layer (150) is aligned with the second periodic structure (411) of the second layer (151) on the upper side (120) of the printed circuit board (100).

8. A printed circuit board according to claim 7, **characterized in that** the first periodic structure (420) of the first layer (160) on the underside (130) of the printed circuit board (100) is arranged on the underside (130) of the printed circuit board (100) in such a way relative to the second periodic structure (421) of the second layer (161) on the underside (130) of the printed circuit board (100) that the periodic structures (420, 421) are arranged offset from one another by half a period (T) and overlap.

9. A printed circuit board according to one of claims 1 to 8, **characterized in that** at least the first and/or the second component (310, 320) is designed as an optoelectronic component, preferably at least the first and/or the second component (310, 320) being designed as an LED, in particular at least the first and/or the second component (310, 320) being designed as a laser diode.

10. A printed circuit board according to one of claims 7 to 9, **characterized in that** at least one operating mode is provided in which the components (310, 320) can be operated alternately.

11. Motor vehicle headlamp comprising one or more printed circuit boards (100) according to one of claims 1 to 10.

## Revendications

1. Carte de circuit imprimé (100) comprenant une couche de base (110) avec une face supérieure et une face inférieure (120, 130), dans laquelle les faces supérieure et inférieure (120, 130) de la carte de circuit imprimé comprennent chacune au moins une première couche (150, 160) de pistes conductrices (200) prévues pour conduire le courant et au moins un premier et un deuxième composants électriques (310, 320), dans lequel en outre au moins deux pistes conductrices (200) sont associées à chaque composant (310, 320, 330, 340) pour l'entraînement des composants, dans lequel des pistes conductrices (200) voisines de chaque côté (120, 130) de la couche de base (110) présentent des surfaces limites (210) espacées les unes des autres pour l'isolation électrique mutuelle, dans lequel au moins la surface limite (210) d'une piste conductrice (200) du premier composant (310) présente au moins par sections un premier ensemble de saillies (401, 405, 501) et la surface limite (210) d'une piste conductrice (200) du deuxième composant (320) voisin présente au moins par sections un deuxième ensemble de saillies (402, 406, 502), dans lequel le premier ensemble de projections (401, 405, 501) et le deuxième ensemble de projections (402, 406, 502) se complètent l'un l'autre, dans lequel le premier et le deuxième ensemble de projections (401, 402, 501, 502) de la au moins une première couche (150) sur la face supérieure (120) de la carte de circuit imprimé forment une première structure périodique (410, 510) avec une période (T),
**caractérisé en ce que**
au moins un troisième et un quatrième composant (330, 340) sont disposés sur la face inférieure (130), dans lequel au moins la surface de délimitation (210) d'une piste conductrice (200) du troisième composant (330) présente au moins par sections un premier jeu de saillies (403, 503) et la surface de délimitation (210) d'une piste conductrice (200) du quatrième composant (340) qui lui fait suite présente au moins par sections un deuxième jeu de saillies (404), 504), dans lequel le premier ensemble de projections (403, 503) et le deuxième ensemble de projections (404, 504) se complètent l'un l'autre, dans lequel le premier et le deuxième ensemble de projections (403, 404, 503, 504) de la au moins une première couche (160) sur la face inférieure (130) de la carte de circuit imprimé forment une première structure périodique (420, 520) avec une période (T), et dans lequel
la première structure périodique (410, 510) de la au moins une première couche (150) sur la face supérieure (120) de la carte de circuit imprimé (100) est disposée de telle manière au-dessus de la première structure périodique (420,520) de la au moins une première couche (160) sur la face inférieure (130) de la carte de circuit imprimé (100), **en ce que** les structures périodiques (410, 420, 510, 520) sont disposées décalées les unes par rapport aux autres d'une demi-période (T) et se chevauchent, de préférence la couche de base (110) présentant un inlay céramique dans la zone de la première structure périodique (410, 420, 510, 520) se trouvant l'une au-dessus de l'autre.

2. Carte de circuit imprimé selon la revendication 1, **caractérisée en ce que** les ensembles de saillies (401, 402, 403, 404) des surfaces limites respectives (210) des pistes conductrices (200) sont formés comme des rectangles en saillie.

3. Carte de circuit imprimé selon la revendication 1, **caractérisée en ce que** les ensembles de saillies (501, 502, 503, 504) des surfaces limites respectives (210) des pistes conductrices (200) sont formés comme des dents en saillie.

4. Carte de circuit imprimé selon l'une quelconque des revendications 1 à 3, **caractérisée en ce qu'**au moins une deuxième couche (151) de pistes conductrices (200) est en outre disposée sur la face supérieure (120) de la carte de circuit imprimé, dans lequel au moins la surface limite (210) d'une piste conductrice (200) présente au moins par sections un premier ensemble de saillies (405) et la surface limite (210) d'une piste conductrice (200) voisine présente au moins par sections un deuxième ensemble de saillies (406), dans lequel le premier ensemble de saillies (405) et le deuxième ensemble de saillies (406) se complètent de manière complémentaire.

5. Carte de circuit imprimé selon l'une des revendications 1 à 4, **caractérisée en ce qu'**au moins une deuxième couche (161) de pistes conductrices (200) est également disposée sur la face inférieure (130) de la carte de circuit imprimé, au moins la surface de délimitation (210) d'une piste conductrice (200) présentant au moins par sections un premier jeu de saillies et la surface de délimitation (210) d'une piste conductrice (200) voisine de celle-ci présentant au moins par sections un deuxième jeu de saillies, le premier jeu de saillies et le deuxième jeu de saillies se complétant de manière complémentaire.

6. Carte de circuit imprimé selon la revendication 4 ou 5, **caractérisée en ce que** le premier et le deuxième ensemble de saillies (405, 406) de la deuxième couche (151) sur la face supérieure (120) de la carte de circuit imprimé forment une deuxième structure périodique (411) avec une période (T).

7. Carte de circuit imprimé selon l'une quelconque des revendications 4 à 6, **caractérisée en ce que** le premier et le second jeu de saillies de la seconde couche (160) sur la face inférieure (130) de la carte de circuit imprimé forment une seconde structure périodique (421) avec une période (T), de préférence la première structure périodique (410) de la première couche (150) sur la face supérieure (120) de la carte de circuit imprimé (100) étant alignée avec la seconde structure périodique (411) de la seconde couche (151) sur la face inférieure (130) de la carte de circuit imprimé (100) de telle sorte que la première structure périodique (410) de la première couche (150) est alignée avec la seconde structure périodique (411) de la seconde couche (151) sur la face supérieure (120) de la carte de circuit imprimé (100).

8. Carte de circuit imprimé selon la revendication 7, **caractérisée en ce que** la première structure périodique (420) de la première couche (160) sur la face inférieure (130) de la carte de circuit imprimé (100) est disposée sur la face inférieure (130) de la carte de circuit imprimé (100) de telle manière par rapport à la deuxième structure périodique (421) de la deuxième couche (161) sur la face inférieure (130) de la carte de circuit imprimé (100) que les structures périodiques (420, 421) sont disposées décalées l'une par rapport à l'autre d'une demi-période (T) et se chevauchent.

9. Carte de circuit imprimé selon l'une des revendications 1 à 8, **caractérisée en ce qu'**au moins le premier et/ou le deuxième composant (310, 320) est conçu comme un composant optoélectronique, de préférence au moins le premier et/ou le deuxième composant (310, 320) étant conçu comme une DEL, en particulier au moins le premier et/ou le deuxième composant (310, 320) étant conçu comme une diode laser.

10. Carte de circuit imprimé selon l'une des revendications 7 à 9, **caractérisée en ce qu'**il est prévu au moins un mode de fonctionnement dans lequel les composants (310, 320) peuvent être utilisés alternativement.

11. projecteur de véhicule automobile comportant une ou plusieurs cartes de circuits imprimés (100) selon l'une des revendications 1 à 10.
